# EUROPEAN PATENT APPLICATION

(11) **EP 4 625 735 A1**
(43) Date of publication of application: **01.10.2025**
(21) Application number: 25162876.4
(22) Date of filing: 11.03.2025
(51) Int. Cl.: H02H 3/10, H02H 3/08, H01H 39/00, H02H 3/24, H02H 7/122, H02H 3/347

(54) **POWER CONVERSION APPARATUS AND SHORT-CIRCUIT PROTECTION METHOD THEREOF, AND PHOTOVOLTAIC POWER GENERATION SYSTEM**

(30) Priority: 28.03.2024 CN 202410366760
(71) Applicant: Huawei Digital Power Technologies Co., Ltd., Shenzhen, Guangdong 518043 (CN)
(72) Inventor: LIU, Shuai, Shenzhen 518043 (CN); QIAN, Bin, Shenzhen 518043 (CN); TANG, Junsong, Shenzhen 518043 (CN); LU, Fenglong, Shenzhen 518043 (CN); GAO, Yongbing, Shenzhen 518043 (CN)
(74) Representative: Gill Jennings & Every LLP

(57) **Abstract**

This application provides a power conversion apparatus (00) and a short-circuit protection method thereof, and a photovoltaic power generation system, and belongs to the field of power electronics technologies. The power conversion apparatus (00) includes an inverter (01), a sampling circuit (02), a controller (03), and a first pyrofuse (04) connected between the inverter (01) and a load (20). The sampling circuit (02) can sample a bus voltage between a positive bus and a negative bus that are connected to a direct current input end of the inverter (01), and an alternating current at an alternating current output end of the inverter (01). The controller (03) can reliably determine, based on a low bus voltage or a large alternating current, that a short-circuit fault occurs in the power conversion apparatus. Therefore, fault detection efficiency is high. In addition, when the short-circuit fault occurs in the power conversion apparatus (00), the controller (03) can further control the first pyrofuse (04) to be blown, to quickly disconnect the inverter (01) from the load (20). In this way, a large current generated due to a short circuit can be quickly prevented from flowing into the load (20) and damaging the load (20), thereby implementing fast short-circuit protection, and further preventing the short-circuit fault from spreading, so that short-circuit protection effect is good.

## Description

### TECHNICAL FIELD

This application relates to the field of power electronics technologies, and in particular, to a power conversion apparatus and a short-circuit protection method thereof, and a photovoltaic power generation system.

### BACKGROUND

A photovoltaic power generation system generally includes a photovoltaic panel and a power conversion apparatus. A direct current side of the power conversion apparatus is connected to the photovoltaic panel, and an alternating current side of the power conversion apparatus is configured to connect to a load. In addition, the power conversion apparatus can convert a direct current (DC) provided by the photovoltaic panel into an alternating current (AC), and transmit the alternating current obtained through conversion to the load, to supply power to the load.

Due to some factors (for example, line aging and a voltage drop), the power conversion apparatus is prone to a short-circuit fault, and a large short-circuit current is generated. Consequently, a component in a device connected to the power conversion apparatus is damaged. Based on this, a circuit breaker is usually disposed on the direct current side or the alternating current side of the power conversion apparatus. When the short-circuit fault occurs in the power conversion apparatus, the circuit breaker can be automatically disconnected on the basis that a current flowing through the circuit breaker reaches a tolerable current threshold, so that the power conversion apparatus is disconnected from the connected device. This prevents a short-circuit current from flowing into the device, and implements short-circuit protection.

However, because it takes specific time for the current to flow through the circuit breaker and reach the current threshold, that is, action time required for disconnecting the circuit breaker is long, efficiency of the short-circuit protection is low, a risk of short-circuit fault spreading exists, and short-circuit protection effect is poor.

### SUMMARY

This application provides a power conversion apparatus and a short-circuit protection method thereof, and a photovoltaic power generation system, to resolve related-technology problems of low short-circuit protection efficiency and poor short-circuit protection effect that are obtained when short-circuit protection is performed on the power conversion apparatus.

According to a first aspect, a power conversion apparatus is provided. The power conversion apparatus includes an inverter, a sampling circuit, a controller, and a first pyrofuse. A direct current input end of the inverter is configured to connect to a direct current power supply through a positive bus and a negative bus, an alternating current output end of the inverter is configured to connect to a load through a plurality of phase wires, the sampling circuit is separately connected to the direct current input end of the inverter, the alternating current output end of the inverter, and the controller, the controller is further connected to the first pyrofuse, and the first pyrofuse is configured to be connected between the alternating current output end of the inverter and the load. The sampling circuit is configured to sample a bus voltage between the positive bus and the negative bus, and an alternating current at the alternating current output end. The controller is configured to: when the bus voltage is less than a first voltage threshold, and/or the alternating current is greater than a current threshold, control the first pyrofuse to be blown.

When the bus voltage is less than the first voltage threshold, and/or the alternating current is greater than the current threshold, it can indicate that a short-circuit fault occurs in the power conversion apparatus. In this way, the controller reliably determines, based on a low bus voltage or a large alternating current, that the short-circuit fault occurs in the power conversion apparatus. Therefore, fault detection efficiency is high. On this basis, when detecting that the short-circuit fault occurs in the power conversion apparatus, the controller further controls the first pyrofuse connected between the inverter and the load to be blown, to quickly disconnect the inverter from the load, thereby quickly preventing a large current generated due to a short circuit from flowing into the load and damaging the load, implementing fast short-circuit protection, and further preventing the short-circuit fault from spreading, so that short-circuit protection effect is good.

Optionally, the power conversion apparatus may further include an alternating current relay connected between the inverter and the load; and the controller may be further configured to: when the bus voltage is less than the first voltage threshold and remains less than the first voltage threshold for first duration, control the alternating current relay to be turned off; and after controlling the alternating current relay to be turned off, and when detecting that energy flowing through the first pyrofuse reaches a blown energy value required for blowing the first pyrofuse, control the first pyrofuse to be blown.

To be specific, in a first embodiment, when detecting that the bus voltage remains less than the first voltage threshold within the first duration, the controller can first control the alternating current relay to be turned off; and then, if detecting that the energy flowing through the first pyrofuse reaches the blown energy value, the controller controls the first pyrofuse to be blown. After the alternating current relay is controlled to be turned off, because contacts of the alternating current relay stick to each other and are not reliably separated, the energy flowing through the first pyrofuse reaches the blown energy value and increases. Therefore, it can be learned that after the controller controls the alternating current relay to be turned off, if the controller determines, based on the energy flowing through the first pyrofuse, that the alternating current relay is not reliably turned off, the controller chooses to control the first pyrofuse to be blown, to reliably disconnect the inverter from the load. Correspondingly, it can be further learned that, after the controller controls the alternating current relay to be turned off, if the controller determines, based on small energy flowing through the first pyrofuse, that the alternating current relay is reliably turned off, the controller does not need to further control the first pyrofuse to be blown. In this way, not only good short-circuit protection can be implemented, but also the first pyrofuse can be further controlled to be blown only in a scenario in which the first pyrofuse needs to be controlled to be blown, and the first pyrofuse is not mistakenly controlled to be blown. Because the first pyrofuse usually needs to be repaired or replaced after the first pyrofuse explodes, problems of high repair or replacement costs and long time required can be resolved.

Optionally, the controller may be configured to: when the bus voltage is less than the first voltage threshold and remains less than the first voltage threshold for the first duration, and the alternating current is less than or equal to the current threshold, control the alternating current relay to be turned off.

On the basis that the bus voltage remains less than the first voltage threshold within the first duration, when the alternating current is less than or equal to the current threshold, it can indicate that a short-circuit fault that occurs in the power conversion apparatus is a non-serious short-circuit fault. To be specific, when detecting that the non-serious short-circuit fault occurs in the power conversion apparatus, the controller can choose to first control the alternating current relay to be turned off; and then, when the alternating current relay is not reliably turned off, the controller further controls the first pyrofuse to be blown.

Optionally, the controller may be further configured to: when the bus voltage is less than a second voltage threshold and remains less than the second voltage threshold for second duration, an average value of the bus voltage in a first time period is greater than a voltage average value threshold and remains greater than the voltage average value threshold for the second duration, and a difference between the average value of the bus voltage in the first time period and an average value of the bus voltage in a second time period is greater than a first voltage difference threshold, control the alternating current relay to be turned off, where the second voltage threshold is less than the first voltage threshold, and duration of the second time period is less than duration of the first time period.

When the bus voltage is less than the second voltage threshold that is less than the first voltage threshold, the controller may infer that a short-circuit fault may be a bus short-circuit fault. In this case, the controller can further reliably determine, based on the average value of the bus voltage in the first time period and the difference between the average value of the bus voltage in the first time period and the average value of the bus voltage in the second time period, whether the short-circuit fault is the bus short-circuit fault. In this way, fault detection precision is good. When the bus short-circuit fault occurs, the controller can first control the alternating current relay to be turned off. It may be understood that, when the bus voltage is less than the first voltage threshold and remains less than the first voltage threshold for the first duration, it can indicate that a short-circuit fault is a short-circuit fault caused by a voltage drop of the direct current power supply. To be specific, the controller can control the inverter to be disconnected from the load in different short-circuit fault scenarios, to implement short-circuit protection. Therefore, short-circuit protection scenarios are comprehensive.

Optionally, the power conversion apparatus may further include an alternating current relay connected between the inverter and the load; and the controller may be further configured to: when the alternating current is greater than the current threshold, control the alternating current relay to be turned off; and after controlling the alternating current relay to be turned off, and when detecting that energy flowing through the first pyrofuse reaches a blown energy value required for blowing the first pyrofuse, control the first pyrofuse to be blown.

To be specific, in the first embodiment, when detecting that the alternating current is greater than the current threshold, the controller can first control the alternating current relay to be turned off; and then, when the alternating current relay is not reliably turned off, the controller further controls the first pyrofuse to be blown. It may be understood that, when the alternating current is greater than the current threshold, it can also indicate that a short-circuit fault is a short-circuit fault caused by a voltage drop of the direct current power supply.

Optionally, when the alternating current is an alternating current output to the load through the alternating current output end, the current threshold may be a first current threshold; and when the alternating current is a sum of alternating current common mode currents of all of the plurality of phase wires connected to the alternating current output end, the current threshold is a second current threshold, the second current threshold is different from the first current threshold, and the controller may be further configured to: when the sum of the alternating current common mode currents is greater than the second current threshold and remains greater than the second current threshold for third duration, control the alternating current relay to be turned off.

That is, for alternating currents in different cases, the controller references different current thresholds. When the sum of the alternating current common mode currents of the phase wires is greater than the second current threshold and remains greater than the second current threshold for the third duration, it can indicate that a short-circuit fault is a short-circuit fault caused by an insulation failure of an energy storage battery in the direct current power supply to the ground. To be specific, when detecting the short-circuit fault caused by the insulation failure of the energy storage battery to the ground, the controller can first control the alternating current relay to be turned off; and then, when the alternating current relay is not reliably turned off, the controller further controls the first pyrofuse to be blown.

Optionally, the controller may be configured to: when the bus voltage is less than the first voltage threshold and remains less than the first voltage threshold for first duration, and the alternating current is greater than the current threshold, control the first pyrofuse to be blown.

To be specific, in a second embodiment, when detecting that a serious short-circuit fault occurs in the power conversion apparatus because the bus voltage remains less than the first voltage threshold within the first duration and the alternating current is greater than the current threshold, the controller can directly control the first pyrofuse to be blown, and does not first control the alternating current relay to be turned off. In this way, a serious fault caused by a delay from time when the alternating current relay is not reliably turned off to time when the first pyrofuse is then controlled to be blown can be prevented from spreading, and good short-circuit protection can be quickly implemented.

Optionally, the controller may be further configured to: when the bus voltage is less than a second voltage threshold and remains less than the second voltage threshold for second duration, the alternating current is greater than the current threshold, an average value of the bus voltage in a first time period is greater than a voltage average value threshold and remains greater than the voltage average value threshold for the second duration, and a difference between the average value of the bus voltage in the first time period and an average value of the bus voltage in a second time period is greater than a first voltage difference threshold, control the first pyrofuse to be blown, where the second voltage threshold may be less than the first voltage threshold, and duration of the second time period may be less than duration of the first time period.

To be specific, when the controller reliably detects a bus short-circuit fault, if the controller determines, based on the alternating current, that the bus short-circuit fault is a serious short-circuit fault, the controller can directly control the first pyrofuse to be blown.

Optionally, the power conversion apparatus may further include a second pyrofuse, and the second pyrofuse may be configured to be connected between the direct current input end of the inverter and the direct current power supply; and the controller may be further configured to: when the bus voltage is less than the first voltage threshold, and/or the alternating current is greater than the current threshold, control the second pyrofuse to be blown.

To be specific, the second pyrofuse can be further disposed at the direct current input end, and when the controller detects that a short-circuit fault occurs in the power conversion apparatus, the controller further controls the second pyrofuse to be blown, to disconnect the inverter from the direct current power supply. In this way, not only a large current generated due to the short-circuit fault can be prevented from flowing into the load through the alternating current output end, but also the large current generated due to the short-circuit fault can be prevented from flowing into the direct current power supply through the direct current input end. Therefore, short-circuit protection effect is better.

According to a second aspect, a power conversion apparatus is provided. The power conversion apparatus includes an inverter, a sampling circuit, a controller, and a first pyrofuse. A direct current input end of the inverter is configured to connect to a direct current power supply through a positive bus and a negative bus, an alternating current output end of the inverter is configured to connect to a load through a plurality of phase wires, the sampling circuit is separately connected to the direct current input end of the inverter, the alternating current output end of the inverter, and the controller, the controller is further connected to the first pyrofuse, and the first pyrofuse is configured to be connected between the alternating current output end of the inverter and the load. The sampling circuit is configured to sample a first half-bus voltage between a bus neutral point and one of the positive bus and the negative bus, and an alternating current at the alternating current output end, where the bus neutral point is a series connection node of two capacitors connected in series between the positive bus and the negative bus. The controller is configured to: when the first half-bus voltage is less than a third voltage threshold, and/or the alternating current is greater than a current threshold, control the first pyrofuse to be blown.

When the first half-bus voltage is less than the third voltage threshold, and/or the alternating current is greater than the current threshold, it can indicate that a short-circuit fault occurs in the power conversion apparatus. Because the first pyrofuse is connected between the alternating current output end of the inverter and the load, when the short-circuit fault occurs in the power conversion apparatus, the controller controls the first pyrofuse to be blown, to quickly disconnect the inverter from the load, thereby preventing a large current generated due to a short circuit from flowing into the load and damaging the load, and implementing good short-circuit protection. It may be understood that when the first half-bus voltage is less than the third voltage threshold, it can indicate that the short-circuit fault is a half-bus short-circuit fault.

Optionally, the power conversion apparatus may further include an alternating current relay connected between the inverter and the load; and the controller may be further configured to: when the first half-bus voltage is less than the third voltage threshold, and the alternating current is greater than the current threshold, control the alternating current relay to be turned off; and after controlling the alternating current relay to be turned off, and when detecting that energy flowing through the first pyrofuse reaches a blown energy value required for blowing the first pyrofuse, control the first pyrofuse to be blown.

To be specific, for a half-bus short-circuit fault, in a first embodiment, when the controller determines, on the basis that the first half-bus voltage is less than the third voltage threshold and the alternating current is greater than the current threshold, that the half-bus short-circuit fault occurs, the controller can first control the alternating current relay to be turned off; and then, when the alternating current relay is not reliably turned off, the controller further controls the first pyrofuse to be blown. In this way, not only good short-circuit protection can be implemented, but also the first pyrofuse can be further controlled to be blown only in a scenario in which the first pyrofuse needs to be controlled to be blown, and the first pyrofuse is not mistakenly controlled to be blown. Because the first pyrofuse usually needs to be repaired or replaced after the first pyrofuse explodes, problems of high repair or replacement costs and long time required can be resolved.

Optionally, the sampling circuit may be further configured to sample a second half-bus voltage between the bus neutral point and the other one of the positive bus and the negative bus; and the controller may be configured to: when the first half-bus voltage is less than the third voltage threshold, the alternating current is greater than the current threshold, and a difference between the first half-bus voltage and the second half-bus voltage is greater than a second voltage difference threshold, control the alternating current relay to be turned off.

To be specific, the controller may further obtain the second half-bus voltage sampled by the sampling circuit; and on the basis that the first half-bus voltage is less than the third voltage threshold and the alternating current is greater than the current threshold, the controller may further reliably determine whether a half-bus short-circuit fault occurs based on the difference between the first half-bus voltage and the second half-bus voltage. Therefore, fault detection precision is higher, and short-circuit protection effect is better.

Optionally, the power conversion apparatus may further include an alternating current relay connected between the inverter and the load; and the controller may be configured to: when the first half-bus voltage is less than the third voltage threshold and remains less than the third voltage threshold for fourth duration, control the alternating current relay to be turned off; and after controlling the alternating current relay to be turned off, and when detecting that energy flowing through the first pyrofuse reaches a blown energy value required for blowing the first pyrofuse, control the first pyrofuse to be blown.

To be specific, for a half-bus short-circuit fault, in a first embodiment, when the controller determines, on the basis that the first half-bus voltage remains less than the third voltage threshold within specific duration, that the half-bus short-circuit fault occurs, the controller can first control the alternating current relay to be turned off; and then, when the alternating current relay is not reliably turned off, the controller further controls the first pyrofuse to be blown.

Optionally, the controller may be configured to: when the first half-bus voltage is less than the third voltage threshold and remains less than the third voltage threshold for the fourth duration, and the alternating current is less than or equal to the current threshold, control the alternating current relay to be turned off.

To be specific, on the basis of detecting that the first half-bus voltage remains less than the third voltage threshold within specific duration, the controller can further determine that a half-bus short-circuit fault is a non-serious half-bus short-circuit fault on the basis that the alternating current is less than or equal to the current threshold. In this case, the controller chooses to first control the alternating current relay to be turned off; and then, when the alternating current relay is not reliably turned off, the controller further controls the first pyrofuse to be blown.

Optionally, the sampling circuit may be further configured to sample a second half-bus voltage between the bus neutral point and the other one of the positive bus and the negative bus; and the controller may be configured to: when the first half-bus voltage is less than the third voltage threshold and remains less than the third voltage threshold for the fourth duration, and a difference between the first half-bus voltage and the second half-bus voltage is greater than a second voltage difference threshold and remains greater than the second voltage difference threshold for the fourth duration, control the alternating current relay to be turned off.

To be specific, for a non-serious half-bus short-circuit fault, the controller can further obtain the second half-bus voltage sampled by the sampling circuit; and on the basis that the first half-bus voltage is less than the third voltage threshold and remains less than the third voltage threshold for the fourth duration, and the alternating current is less than or equal to the current threshold, the controller can further reliably determine whether the half-bus short-circuit fault occurs based on the difference between the first half-bus voltage and the second half-bus voltage. Therefore, fault detection precision is higher, and short-circuit protection effect is better.

Optionally, the controller may be configured to: when the first half-bus voltage is less than the third voltage threshold and remains less than the third voltage threshold for fourth duration, and the alternating current is greater than the current threshold, control the first pyrofuse to be blown.

To be specific, for a half-bus short-circuit fault, in a second embodiment, when the controller detects that the half-bus short-circuit fault is a serious half-bus short-circuit fault because the first half-bus voltage remains less than the third voltage threshold within the fourth duration and the alternating current is greater than the current threshold, the controller can directly control the first pyrofuse to be blown, and does not first control the alternating current relay to be turned off. In this way, a serious fault caused by a delay from time when the alternating current relay is not reliably turned off to time when the first pyrofuse is then controlled to be blown can be prevented from spreading, and good short-circuit protection can be quickly implemented.

Optionally, the sampling circuit may be further configured to: sample a second half-bus voltage between the bus neutral point and the other one of the positive bus and the negative bus; and the controller may be configured to: when the first half-bus voltage is less than the third voltage threshold and remains less than the third voltage threshold for the fourth duration, the alternating current is greater than the current threshold, and a difference between the first half-bus voltage and the second half-bus voltage is greater than a second voltage difference threshold and remains greater than the second voltage difference threshold for the fourth duration, control the first pyrofuse to be blown.

To be specific, when the controller reliably detects a half-bus short-circuit fault, if the controller further determines, based on the alternating current, that the bus short-circuit fault is a serious short-circuit fault, the controller can directly control the first pyrofuse to be blown.

According to a third aspect, a short-circuit protection method for a power conversion apparatus is provided. The method includes: obtaining a bus voltage between a positive bus and a negative bus, and an alternating current at an alternating current output end, where the power conversion apparatus includes an inverter, a direct current input end of the inverter is configured to connect to a direct current power supply through the positive bus and the negative bus, and the alternating current output end of the inverter is configured to connect to a load through a plurality of phase wires; and when the bus voltage is less than a first voltage threshold, and/or the alternating current is greater than a current threshold, controlling a first pyrofuse to be blown, where the power conversion apparatus further includes the first pyrofuse, and the first pyrofuse is configured to be connected between the alternating current output end of the inverter and the load.

According to a fourth aspect, a photovoltaic power generation system is provided. The photovoltaic power generation system includes a power conversion apparatus and a first pyrofuse. A direct current input end of the power conversion apparatus is configured to connect to a photovoltaic panel or an energy storage battery through a positive bus and a negative bus, an alternating current output end of the power conversion apparatus is configured to connect to a load or a power grid, and the first pyrofuse is configured to be connected between the power conversion apparatus and the load or the power grid. The power conversion apparatus is configured to: convert a direct current provided by the photovoltaic panel or the energy storage battery into an alternating current, and then output the alternating current to the load or the power grid, and is further configured to: sample a bus voltage between the positive bus and the negative bus, and an alternating current at the alternating current output end; and when the bus voltage is less than a first voltage threshold, and/or the alternating current is greater than a current threshold, control the first pyrofuse to be blown, to disconnect from the load or the power grid.

Optionally, the photovoltaic power generation system further includes an energy storage cabinet, and both the energy storage battery and the first pyrofuse are disposed in the energy storage cabinet.

In conclusion, this application provides the power conversion apparatus and the short-circuit protection method thereof, and the photovoltaic power generation system. In the solutions provided in this application, the power conversion apparatus includes the inverter, the sampling circuit, the controller, and the first pyrofuse connected between the inverter and the load. The sampling circuit can sample the bus voltage between the positive bus and the negative bus that are connected to the direct current input end of the inverter (or the half-bus voltage between the bus neutral point and the positive bus and/or the negative bus), and the alternating current at the alternating current output end of the inverter. The controller can reliably determine, based on a low bus voltage (or a low half-bus voltage) or a large alternating current, that a short-circuit fault occurs in the power conversion apparatus. Therefore, fault detection efficiency is high. In addition, when determining that the short-circuit fault occurs in the power conversion apparatus, the controller can further control the first pyrofuse to be blown. In other words, the first pyrofuse can be quickly blown under control of the controller, so that the inverter is quickly disconnected from the load. In this way, a large current generated due to a short circuit can be quickly prevented from flowing into the load and damaging the load, thereby implementing fast short-circuit protection, and further preventing the short-circuit fault from spreading, so that short-circuit protection effect is good.

### BRIEF DESCRIPTION OF DRAWINGS

FIG. 1 is a diagram of a working scenario of a power conversion apparatus according to an embodiment of this application;
FIG. 2 is a diagram of a structure of a power conversion apparatus according to an embodiment of this application;
FIG. 3 is a diagram of a structure of another power conversion apparatus according to an embodiment of this application;
FIG. 4 is a diagram of a circuit topology structure of an inverter according to an embodiment of this application;
FIG. 5 is a diagram of a structure of still another power conversion apparatus according to an embodiment of this application; and
FIG. 6 is a diagram of a structure of yet another power conversion apparatus according to an embodiment of this application.

### DESCRIPTION OF EMBODIMENTS

The following describes in detail a power conversion apparatus and a short-circuit protection method thereof, and a photovoltaic power generation system provided in embodiments of this application with reference to accompanying drawings. Key terms in embodiments of this application are first described.

A photovoltaic panel may also be referred to as a solar panel, and is an apparatus configured to convert solar energy into direct current electric energy through photovoltaic effect.

A battery pack (pack) is a common energy storage battery used to provide a direct current DC. The battery pack generally includes a plurality of battery groups, and each battery group further includes a plurality of electrochemical cells, that is, a plurality of battery cells (cell). In other words, the battery pack is an energy storage battery including a plurality of electrochemical cells.

Insulation failure of a battery to the ground: Batteries usually use a floating ground design, that is, are insulated from the ground. It can be learned that the insulation failure of the battery to the ground means that insulation between the battery and the ground fails. Once the insulation fails, a fault loop is formed in the battery, and a large current is generated, causing heat, fire, or personal injury.

An inverter is a power converter configured to convert a direct current DC provided by a direct current power supply (for example, a photovoltaic panel or an energy storage battery) into an alternating current AC, and is a unidirectional DC/AC power converter.

A bus is routing for establishing a connection between a direct current input end of an inverter and a direct current power supply, or is referred to as a direct current port of the inverter. The direct current power supply usually includes a positive electrode and a negative electrode. Correspondingly, the bus generally includes a positive bus BUS+ and a negative bus BUS-. The positive bus BUS+ is connected to the positive electrode of the direct current power supply, and the negative bus BUS- is connected to the negative electrode of the direct current power supply.

Half-bus: A direct current input end of an inverter usually uses a solution of connecting capacitors in series. To be specific, two capacitors are connected in series between a positive bus BUS+ and a negative bus BUS-, and a series connection node of the two capacitors is referred to as a bus neutral point. The half-bus is a connection line from the positive bus BUS+ or the negative bus BUS- to the bus neutral point. A connection line between the positive bus BUS+ and the bus neutral point is referred to as a positive half-bus, and a connection line between the negative bus BUS- and the bus neutral point is referred to as a negative half-bus.

Stop sending a PWM driver gating signal: A photovoltaic power generation system usually includes an inverter and an inverter drive circuit, and the inverter drive circuit may output a pulse-width modulation (pulse-width modulation, PWM) signal to the inverter, to control the inverter to operate. The PWM signal is also referred to as a PWM wave. Correspondingly, stopping sending a PWM driver gating signal may mean that the inverter drive circuit stops outputting the PWM wave to the inverter, to control the inverter to stop operating.

A pyrofuse (pyrofuse) may also be referred to as an excitation fuse, a high-temperature fuse, a smoke and fire control switch, or an instantaneous circuit breaker, and can quickly generate explosion impact after receiving a blown trigger signal, so that two parts connected to each other through the pyrofuse are disconnected, and action time is short.

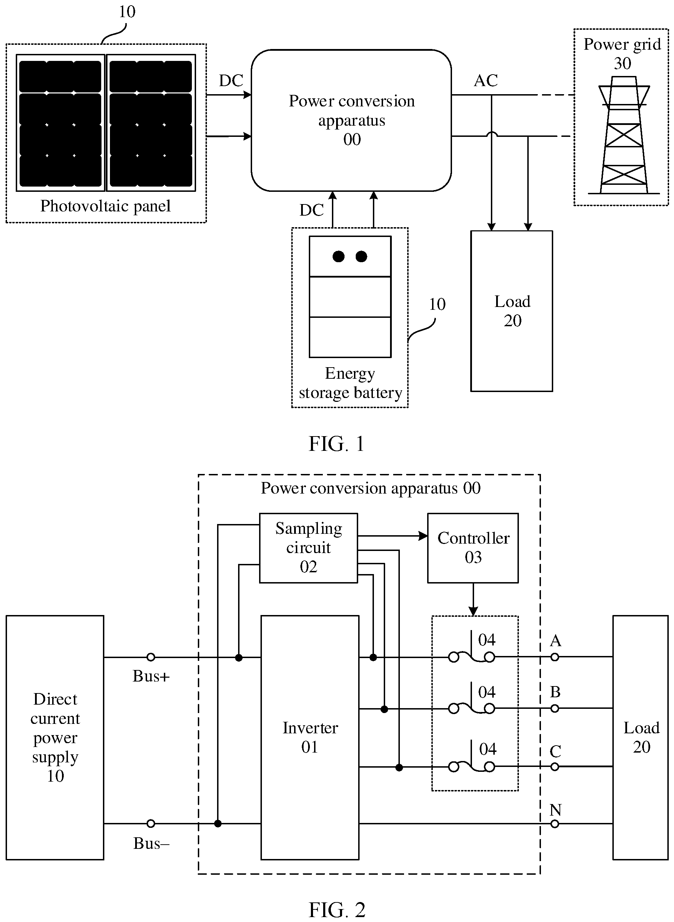

FIG. 1 shows a diagram of a possible scenario applicable to embodiments of this application. Refer to FIG. 1. The scenario includes a direct current power supply 10 and a power conversion apparatus 00. The power conversion apparatus 00 is connected to the direct current power supply 10, and can convert a direct current DC provided by the direct current power supply 10 into an alternating current AC. Optionally, the direct current power supply 10 may include, for example, photovoltaic panels or energy storage batteries shown in FIG. 1. In addition, it can be further seen from FIG. 1 that the scenario may further include a load 20 and/or a power grid 30. The power conversion apparatus 00 may be connected to the load 20 and/or the power grid 30, and can output an alternating current AC obtained through conversion to the load 20 and/or the power grid 30.

FIG. 2 is a diagram of a structure of the power conversion apparatus 00 according to an embodiment of this application. The power conversion apparatus 00 has a short-circuit protection function, and can cut off a short-circuit loop in time, to prevent short-circuit energy (for example, a large current generated due to a short circuit) from flowing into a device (for example, a photovoltaic panel, an energy storage battery, or a load) connected to the power conversion apparatus 00 and damaging a component in the device. As shown in FIG. 2, the power conversion apparatus 00 includes an inverter 01, a sampling circuit 02, a controller 03, and first pyrofuses 04. A direct current input end of the inverter 01 is configured to connect to a direct current power supply 10 through a positive bus BUS+ and a negative bus BUS-, an alternating current output end of the inverter 01 is configured to connect to a load 20 (or a power grid 30) through a plurality of phase wires, the sampling circuit 02 is separately connected to the direct current input end of the inverter 01, the alternating current output end of the inverter 01, and the controller 03, the controller 03 is further connected to the first pyrofuses 04, and the first pyrofuse 04 is configured to be connected between the alternating current output end of the inverter 01 and the load 20.

For example, refer to FIG. 2. The alternating current output end of the inverter 01 shown in FIG. 2 is connected to the load 20 through three phase wires A, B, and C, and is further connected to the load 20 through a neutral wire N. The inverter 01 in this structure is also referred to as a three-phase inverter. Certainly, in some other embodiments, the inverter 01 may alternatively be another type of multiphase inverter, or the inverter 01 may be replaced with another power converter that can convert a direct current DC into an alternating current AC. For example, the inverter 01 may be replaced with a bidirectional DC/AC power conversion system (power conversion system, PCS) that can convert a direct current DC into an alternating current AC and convert an alternating current AC into a direct current DC. In addition, it can be further seen from FIG. 2 that, using the three-phase inverter as an example, the sampling circuit 02 may be connected to all of the three phase wires A, B, and C that are connected to the alternating current output end. In addition, the power conversion apparatus 00 may include three first pyrofuses 04 that one-to-one correspond to the three phase wires A, B, and C, that is, one first pyrofuse 04 may be disposed on each phase wire. The controller 03 may be connected to each first pyrofuse 04. Certainly, in some other embodiments, a first pyrofuse 04 may alternatively be disposed on the neutral wire N.

The sampling circuit 02 is configured to sample a bus voltage between the positive bus+ and the negative bus- and an alternating current at the alternating current output end.

To be specific, in this embodiment of this application, as shown in FIG. 2, sampling points are respectively disposed at the direct current input end and the alternating current output end that are of the inverter 01 for the sampling circuit 02 to connect, and the sampling circuit 02 samples a direct current voltage at the direct current input end and the alternating current at the alternating current output end. The direct current voltage includes a bus voltage between the positive bus BUS+ and the negative bus BUS- that are connected to the direct current input end, that is, a voltage difference between a direct current voltage Vdc+ on the positive bus BUS+ and a direct current voltage Vdc- on the negative bus BUS-. The alternating current includes a current output to the load 20 through the alternating current output end.

The controller 03 is configured to: when the bus voltage is less than a first voltage threshold, and/or the alternating current is greater than a current threshold, control the first pyrofuse 04 to be blown (that is, trigger the first pyrofuse 04 to explode).

When the bus voltage is less than the first voltage threshold, or the alternating current is greater than the current threshold, it can indicate that a short-circuit fault occurs in the power conversion apparatus 00. To be specific, in this embodiment of this application, the controller 03 can obtain the bus voltage and the alternating current by using the sampling circuit 02; and when detecting that the short-circuit fault occurs in the power conversion apparatus 00 due to a low bus voltage and/or a large alternating current, the controller 03 can control the first pyrofuse 04 to be blown, to disconnect the alternating current output end of the inverter 01 from the load 20, thereby preventing a large current generated due to the short-circuit fault from flowing into the load 20 and damaging a component in the load 20, and implementing short-circuit protection.

In other words, the controller 03 can detect, based on the direct current voltage at the direct current input end of the inverter 01 and the alternating current at the alternating current output end of the inverter 01, whether the short-circuit fault occurs in the power conversion apparatus 00. In this way, fault transfer time is short, fault detection precision is good, and fault detection efficiency is high. In addition, when detecting that the short-circuit fault occurs in the power conversion apparatus 00, the controller 03 can control the first pyrofuse 04 to be blown within short action time, to quickly disconnect the alternating current output end of the inverter 01 from the load 20, that is, quickly disconnect a short-circuit loop, thereby implementing fast short-circuit protection. In this way, compared with a conventional solution in which a circuit breaker with long action time is disposed to implement short-circuit protection, this solution can improve efficiency of short-circuit protection, to prevent the short-circuit fault from spreading, so that a component in a device (for example, the load 20) connected to the power conversion apparatus 00 does not need to bear a large short-circuit current when a short-circuit path is not cut off, thereby ensuring good short-circuit protection effect.

It may be understood that both the voltage threshold and the current threshold in embodiments of this application may be fixed values pre-stored in the controller 03, and certainly may alternatively be flexibly adjusted based on a use scenario.

In conclusion, this embodiment of this application provides the power conversion apparatus. The power conversion apparatus includes the inverter, the sampling circuit, the controller, and the first pyrofuse connected between the inverter and the load. The sampling circuit can sample the bus voltage between the positive bus and the negative bus that are connected to the direct current input end of the inverter, and the alternating current at the alternating current output end of the inverter. The controller can reliably determine, based on a low bus voltage or a large alternating current, that a short-circuit fault occurs in the power conversion apparatus. Therefore, fault detection efficiency is high. In addition, when determining that the short-circuit fault occurs in the power conversion apparatus, the controller can further control the first pyrofuse to be blown. In other words, the first pyrofuse can be quickly blown under control of the controller, so that the inverter is quickly disconnected from the load. In this way, a large current generated due to a short circuit can be quickly prevented from flowing into the load and damaging the load, thereby implementing fast short-circuit protection, and further preventing the short-circuit fault from spreading, so that short-circuit protection effect is good.

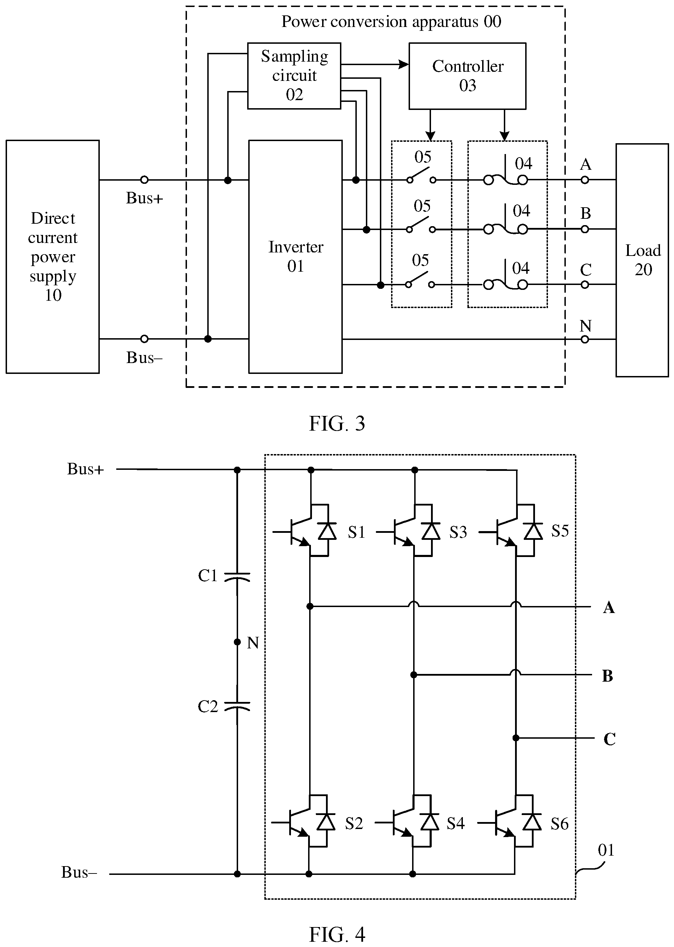

Optionally, as shown in FIG. 3, the power conversion apparatus 00 may further include alternating current relays 05 connected between the inverter 01 and the load 20. For example, refer to FIG. 3. In a scenario in which the inverter 01 is a three-phase inverter, the power conversion apparatus 00 may include an alternating current relay 05 connected to each phase wire. The first pyrofuse 04 may be connected between the alternating current relay 05 and the load 20. Certainly, in some other embodiments, an alternating current relay 05 may alternatively be disposed on the neutral wire N.

It may be understood that the alternating current relay 05 is a relay that can withstand an alternating current and has a switching function. The alternating current relay 05 usually includes components such as an electromagnet, contacts (including a movable contact and a static contact), and a spring. When the electromagnet is activated, a magnetic field may be generated, to attract or release the contacts, so that the relay is open or closed. When the relay is open, the relay is turned off, and the contacts are separated; and when the relay is closed, the relay is turned on, and the contacts are connected. When the alternating current relay 05 is connected between the inverter 01 and the load 20, if the alternating current relay 05 is turned off, the inverter 01 is disconnected from the load 20, and if the alternating current relay 05 is turned on, the inverter 01 is connected to the load 20.

Optionally, in a first embodiment, the controller 03 may be further configured to: when the bus voltage is less than the first voltage threshold and remains less than the first voltage threshold for first duration, control the alternating current relay 05 to be turned off; and after controlling the alternating current relay 05 to be turned off, and when detecting that energy flowing through the first pyrofuse 04 reaches a blown energy value required for the first pyrofuse 04 to be blown, control the first pyrofuse 04 to be blown.

The energy flowing through the first pyrofuse 04 may be energy of an alternating current flowing through the first pyrofuse 04 within specific duration. The blown energy value is a maximum energy value that can be borne by the first pyrofuse 04. Once the energy flowing through the first pyrofuse 04 reaches the blown energy value, the first pyrofuse 04 can be triggered to explode.

To be specific, in this embodiment of this application, when detecting that a short-circuit fault occurs in the power conversion apparatus 00 because the bus voltage remains less than the first voltage threshold within the first duration, the controller 03 can first control the alternating current relay 05 connected between the inverter 01 and the load 20 to be turned off, to disconnect the inverter 01 from the load 20, and does not directly control the first pyrofuse 04 to be blown. After the alternating current relay 05 is controlled to be turned off for specific duration, if the controller 03 detects that the energy flowing through the first pyrofuse 04 reaches the blown energy value, the controller 03 further controls the first pyrofuse 04 to be blown. In other words, after the controller 03 controls the alternating current relay 05 to be turned off, if the controller 03 detects that the energy flowing through the first pyrofuse 04 does not reach the blown energy value, the controller 03 does not control the first pyrofuse 04 to be blown.

It may be understood that, because the contacts of the alternating current relay 05 are usually metal contacts, when the controller 03 controls the alternating current relay 05 to be turned off, there is a risk that the contacts of the alternating current relay 05 stick to each other due to some factors (for example, large heat). When the alternating current relay 05 is not reliably turned off because the contacts of the alternating current relay 05 stick to each other, the inverter 01 cannot be reliably disconnected from the load 20, and the energy flowing through the first pyrofuse 04 increases. On the contrary, when the alternating current relay 05 is reliably turned off because the contacts of the alternating current relay 05 do not stick to each other, the inverter 01 can be reliably disconnected from the load 20, and the energy flowing through the first pyrofuse 04 generally does not increase, and correspondingly decreases.

It can be learned that, in the first embodiment, when the short-circuit fault occurs in the power conversion apparatus 00, the controller 03 may first control the alternating current relay 05 to be turned off; and then, if the controller 03 determines, based on the energy flowing through the first pyrofuse 04, that the alternating current relay 05 is not reliably turned off, the controller 03 may further control the first pyrofuse 04 to be blown; or if the controller 03 determines, based on the energy flowing through the first pyrofuse 04, that the alternating current relay 05 is reliably turned off, the controller 03 does not need to further control the first pyrofuse 04 to be blown. In this way, the alternating current relay 05 is controlled to be turned off, and the first pyrofuse 04 is selectively controlled to be blown, so that not only the inverter 01 can be reliably disconnected from the load 20, to implement good short-circuit protection, but also the first pyrofuse 04 can be further controlled to be blown only in a scenario in which the first pyrofuse 04 needs to be controlled to be blown, and the first pyrofuse 04 is not mistakenly controlled to be blown. It may be understood that, because the first pyrofuse 04 usually needs to be repaired or replaced after the first pyrofuse 04 explodes, problems of high repair or replacement costs and long time required can be resolved while avoiding mistakenly controlling the first pyrofuse 04 to be blown.

It may be understood that both the duration and the blown energy value in embodiments of this application may alternatively be fixed values pre-stored in the controller 03, and certainly may alternatively be flexibly adjusted based on a use scenario.

It may be further understood that an instantaneous value of the bus voltage at a moment is less than a voltage threshold (for example, the first voltage threshold) due to some other factors instead of the short-circuit fault in the power conversion apparatus 00. Therefore, fault detection precision is better by configuring the controller 03 to detect, on the basis that the bus voltage remains less than the voltage threshold for a continuous period of time (for example, the first duration), whether the short-circuit fault occurs in the power conversion apparatus 00. Certainly, in some other embodiments, when the instantaneous value of the bus voltage is less than the voltage threshold, the controller 03 may alternatively control the alternating current relay 05 to be turned off, to implement better short-circuit protection. Effects of other voltage thresholds and other duration recorded below are similar. Details are not described again.

Optionally, for the foregoing first embodiment, the controller 03 may be configured to: when the bus voltage is less than the first voltage threshold and remains less than the first voltage threshold for the first duration, and the alternating current is less than or equal to the current threshold, control the alternating current relay 05 to be turned off.

As described above, when the bus voltage is less than the first voltage threshold and remains less than the first voltage threshold for the first duration, it can indicate that a short-circuit fault occurs in the power conversion apparatus 00. On the basis that the bus voltage is less than the first voltage threshold and remains less than the first voltage threshold for the first duration, when the alternating current is less than or equal to the current threshold, it can indicate that the short-circuit fault that occurs in the power conversion apparatus 00 in this case is a non-serious short-circuit fault. Correspondingly, it can be further learned that, on the basis that the bus voltage is less than the first voltage threshold and remains less than the first voltage threshold for the first duration, when the alternating current is greater than the current threshold, it can indicate that the short-circuit fault that occurs in the power conversion apparatus 00 is a serious short-circuit fault.

To be specific, in this embodiment of this application, for the non-serious short-circuit fault, the controller 03 can first control the alternating current relay 05 to be turned off; and then when determining, based on the energy flowing through the first pyrofuse 04, that the alternating current relay 05 is not reliably turned off, the controller 03 further controls the first pyrofuse 04 to be blown, to implement short-circuit protection. For the serious short-circuit fault, because there is a delay from time when the alternating current relay 05 is first controlled to be turned off to time when the first pyrofuse 04 is then controlled to be blown, the controller 03 may be configured to directly control the first pyrofuse 04 to be blown, and does not first control the alternating current relay 05 to be turned off.

It may be understood that the current threshold in embodiments of this application may be a fixed value pre-stored in the controller 03, and certainly may alternatively be flexibly adjusted based on a use scenario.

It may be further understood that a short-circuit fault determined by the controller 03 when the controller 03 detects that the bus voltage is less than the first voltage threshold and remains less than the first voltage threshold for the first duration may be a short circuit caused by a pack voltage drop when the direct current power supply 10 includes a pack. This is also referred to as a single-stage pack short-circuit fault. That is, in an implementation, the controller 03 can implement short-circuit protection for the single-stage pack short-circuit fault.

Optionally, in this embodiment of this application, the controller 03 may be further configured to: when the bus voltage is less than a second voltage threshold and remains less than the second voltage threshold for second duration, an average value of the bus voltage in a first time period is greater than a voltage average value threshold and remains greater than the voltage average value threshold for the second duration, and a difference between the average value of the bus voltage in the first time period and an average value of the bus voltage in a second time period is greater than a first voltage difference threshold, control the alternating current relay 05 be turned off.

The second voltage threshold is less than the first voltage threshold, and duration of the second time period is less than duration of the first time period. When the bus voltage is less than the first voltage threshold, it can indicate that a short-circuit fault occurs in the power conversion apparatus 00. Therefore, when the bus voltage is less than the second voltage threshold and remains less than the second voltage threshold for the second duration, it can correspondingly indicate that a short-circuit fault occurs in the power conversion apparatus 00. In addition, when the average value of the bus voltage in the first time period is greater than the voltage average value threshold and remains greater than the voltage average value threshold for the second duration, it can indicate that the bus voltage drops. The difference between the average value of the bus voltage in the first time period and the average value of the bus voltage in the second time period can indicate a bus short circuit caused by a large drop value of the bus voltage. The bus short circuit may mean that a short circuit occurs between the positive bus BUS+ and the negative bus BUS-.

To be specific, in this embodiment of this application, if the controller 03 detects that the bus voltage is less than the second voltage threshold that is less than the first voltage threshold within specific duration, the controller 03 may infer that a short-circuit fault that occurs in the power conversion apparatus 00 may be a bus short-circuit fault instead of a single-stage pack short-circuit fault. In this case, the controller 03 may further reliably determine, based on the average value of the bus voltage in the first time period and the difference between the average value of the bus voltage in the first time period and the average value of the bus voltage in the second time period, whether the short-circuit fault that occurs in the power conversion apparatus 00 is a bus short-circuit. Therefore, fault detection precision is good. In addition, when determining that the bus short-circuit fault occurs, the controller 03 may first control the alternating current relay 05 to be turned off. That is, in another implementation, the controller 03 can further implement short-circuit protection for the bus short-circuit fault.

Certainly, in some embodiments, when the controller 03 detects that the bus voltage is less than the second voltage threshold and remains less than the second voltage threshold for the second duration, that is, when the controller 03 infers that a short-circuit fault that occurs in the power conversion apparatus 00 may be a bus short-circuit fault, the controller 03 can further directly control the alternating current relay 05 to be turned off, and does not further determine whether the short-circuit fault is the bus short-circuit fault based on the average value of the bus voltage in the first time period and the difference between the average value of the bus voltage in the first time period and the average value of the bus voltage in the second time period. That is, the first voltage threshold in the foregoing embodiment may alternatively be equal to the second voltage threshold.

In addition, in some embodiments, when detecting that the bus voltage is less than the second voltage threshold and remains less than the second voltage threshold for the second duration, the average value of the bus voltage in the first time period is greater than the voltage average value threshold and remains greater than the voltage average value threshold for the second duration, and the difference between the average value of the bus voltage in the first time period and the average value of the bus voltage in the second time period is greater than the first voltage difference threshold, the controller 03 can further determine, on the basis that a detected alternating current is less than or equal to the current threshold, that a bus short-circuit fault in this case is a non-serious bus short-circuit fault, and then choose to first control the alternating current relay 05 to be turned off.

It may be understood that a time period (for example, the first time period) in embodiments of this application may alternatively be a fixed value pre-stored in the controller 03, and certainly may alternatively be flexibly adjusted based on a use scenario. In addition, the time period may be represented by a sliding window, an average value in a long time period (for example, the first time period) may be referred to as a long-term sliding window average value, and an average value in a short time period (for example, the second time period) may be referred to as a short-term sliding window average value. The sliding window collects statistics on data in each time period in a time sequence, to obtain a feature of data in each time period.

It may be further understood that the difference in embodiments of this application may be an absolute value of the difference.

Alternatively, in the first embodiment, the controller 03 may be further configured to: when the alternating current is greater than the current threshold, control the alternating current relay 05 to be turned off; and after controlling the alternating current relay 05 to be turned off, and when detecting that the energy flowing through the first pyrofuse 04 reaches the blown energy value required for the first pyrofuse 04 to be blown, control the first pyrofuse 04 to be blown.

To be specific, in this embodiment of this application, when detecting that a short-circuit fault occurs in the power conversion apparatus 00 because the alternating current is greater than the current threshold, the controller 03 can first control the alternating current relay 05 connected between the inverter 01 and the load 20 to be turned off, to disconnect the inverter 01 from the load 20, and does not directly control the first pyrofuse 04 to be blown. After controlling the alternating current relay 05 to be turned off, if the controller 03 determines, based on the energy flowing through the first pyrofuse 04, that the alternating current relay 05 is not reliably turned off, the controller 03 further controls the first pyrofuse 04 to be blown, to reliably disconnect the inverter 01 from the load 20. Otherwise, if the controller 03 determines, based on the energy flowing through the first pyrofuse 04, that the alternating current relay 05 has been reliably turned off, the controller 03 no longer controls the first pyrofuse 04 to be blown.

Optionally, as described above, the alternating current may include the current output to the load through the alternating current output end, and certainly may also include an alternating current common mode current of each of the plurality of phase wires connected to the alternating current output end, that is, a current of a loop formed between each phase wire and the ground.

When the alternating current is the alternating current output to the load 20 through the alternating current output end, the current threshold in this embodiment of this application may be a first current threshold. In this case, a short-circuit fault determined by the controller 03 on the basis that the alternating current is greater than the first current threshold may be a single-stage pack short-circuit fault.

When the alternating current is a sum of alternating current common mode currents of the plurality of phase wires connected to the alternating current output end, the current threshold in this embodiment of this application may be a second current threshold, and the second current threshold may be different from the first current threshold. To be specific, the controller 03 may further determine the sum of the alternating current common mode currents of all the phase wires, and when detecting that the sum of the alternating current common mode currents of all the phase wires is greater than the second current threshold, the controller 03 controls the alternating current relay 05 to be turned off.

In addition, in some embodiments, the controller 03 may be further configured to: when the sum of the alternating current common mode currents is greater than the second current threshold and remains greater than the second current threshold for third duration, control the alternating current relay 05 to be turned off. In other words, when detecting that the sum of the alternating current common mode currents remains greater than the second current threshold within specific duration, the controller 03 may determine that a short-circuit fault occurs in the power conversion apparatus 00, and control the alternating current relay 05 to be turned off. In this way, compared with a case in which the controller 03 determines that the short-circuit fault occurs in the power conversion apparatus 00 when detecting that an instantaneous value of the sum of the alternating current common mode currents is greater than the second current threshold, this manner provides higher short-circuit fault detection precision and better short-circuit protection effect.

It may be understood that the short-circuit fault determined by the controller 03 when the controller 03 detects that the sum of the alternating current common mode currents of all the phase wires is greater than the second current threshold and remains greater than the second current threshold for the third duration may be a short circuit caused by an insulation failure, to the ground, of a positive electrode and a negative electrode that are of an energy storage battery when the direct current power supply 10 includes the energy storage battery, and is also referred to as a short-circuit fault due to the insulation failure of the energy storage battery to the ground. That is, in still another implementation, the controller 03 can further implement short-circuit protection for the short-circuit fault due to the insulation failure of the energy storage battery to the ground.

Optionally, in this embodiment of this application, when controlling the alternating current relay to be turned off, the controller 03 may further control a semiconductor device in the inverter 01 to stop operating, so that the inverter 01 stops outputting an alternating current.

For example, refer to FIG. 4. The semiconductor device may include a power transistor in the inverter 01, and for a three-phase inverter, the inverter 01 may include six power transistors S1 to S6. The controller 03 may stop outputting a PWM wave to the power transistors in the inverter 01, to control the power transistors to be turned off, that is, to enable the power transistors to stop operating. As described above, that the controller 03 stops outputting the PWM wave may also be referred to as stopping sending a PWM driver gating signal.

Optionally, for the inverter 01, the power conversion apparatus 00 may include an inverter drive circuit, and the controller 03 may be connected to the inverter 01 through the inverter drive circuit, and may deliver an instruction for waveform generation cutoff to the inverter drive circuit, to indicate the inverter drive circuit to stop outputting a PWM wave to the inverter 01. Similarly, for the alternating current relay 05, the power conversion apparatus may also include an alternating current relay drive circuit, and the controller 03 may be connected to the alternating current relay 05 through the alternating current relay drive circuit, and may output a turn-off instruction to the alternating current relay drive circuit, to indicate the alternating current relay drive circuit to control the alternating current relay 05 to be turned off.

It may be understood that the alternating current relay 05 is controlled to be turned off, and the semiconductor device in the inverter 01 is controlled to stop operating, so that the inverter 01 can reliably stop outputting the alternating current, thereby reliably preventing a large current generated due to a short-circuit fault from flowing into the load 20, and implementing good short-circuit protection.

Optionally, in a second embodiment, the controller 03 may be configured to: when the bus voltage is less than the first voltage threshold and remains less than the first voltage threshold for first duration, and the alternating current is greater than the current threshold, control the first pyrofuse 04 to be blown.

With reference to the foregoing descriptions, on the basis that the bus voltage is less than the first voltage threshold and remains less than the first voltage threshold for the first duration, when the alternating current is still greater than the current threshold, it can indicate that a serious short-circuit fault occurs in the power conversion apparatus 00. To be specific, in this embodiment of this application, when detecting that the serious short-circuit fault occurs in the power conversion apparatus 00, the controller 03 can directly control the first pyrofuse 04 to be blown, to disconnect the inverter 01 from the load 20, and implement short-circuit protection, and does not first control the alternating current relay 05 to be turned off. In this way, a serious fault caused by a delay from time when the alternating current relay 05 is not reliably turned off to time when the first pyrofuse 04 is then controlled to be blown can be prevented from spreading, and good short-circuit protection can be quickly implemented.

Optionally, the controller 03 may be further configured to: when the bus voltage is less than a second voltage threshold and remains less than the second voltage threshold for second duration, the alternating current is greater than the current threshold, an average value of the bus voltage in a first time period is greater than a voltage average value threshold and remains greater than the voltage average value threshold for the second duration, and a difference between the average value of the bus voltage in the first time period and an average value of the bus voltage in a second time period is greater than a first voltage difference threshold, control the first pyrofuse 04 to be blown.

The second voltage threshold is less than the first voltage threshold, and duration of the second time period is less than duration of the first time period. To be specific, as described above, on the basis of detecting that the bus voltage is less than the second voltage threshold and remains less than the second voltage threshold for the second duration, the controller 03 can reliably detect whether a bus short-circuit fault occurs based on the average value of the bus voltage in the first time period and the difference between the average value of the bus voltage in the first time period and the average value of the bus voltage in the second time period. In addition, on this basis, if the controller 03 further determines, based on the alternating current, that the bus short-circuit fault is a serious short-circuit fault, the controller 03 may directly control the first pyrofuse 04 to be blown. Certainly, as described above, in some embodiments, when the controller 03 detects that the bus voltage is less than the second voltage threshold and remains less than the second voltage threshold for the second duration, that is, when the controller 03 infers that a bus short-circuit fault may occur, if the controller 03 further determines, based on the alternating current, that the bus short-circuit fault is a serious short-circuit fault, the controller 03 directly controls the first pyrofuse 04 to be blown.

It may be understood that a serious short-circuit fault in another short-circuit fault scenario is similar. In this case, the controller 03 can directly control the first pyrofuse 04 to be blown, to reliably and quickly disconnect the inverter 01 from the load 20, thereby implementing better short-circuit protection.

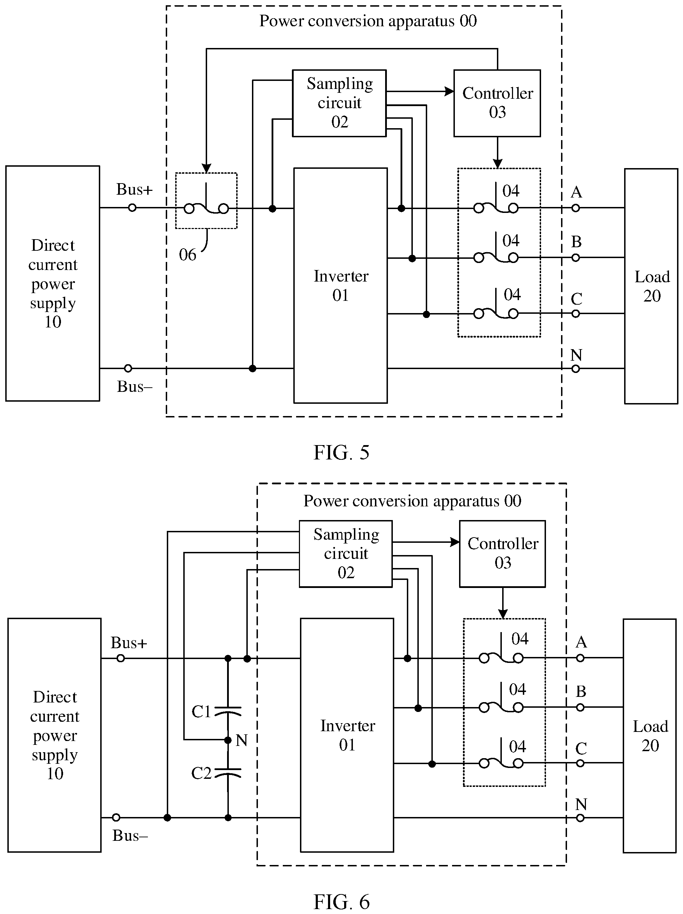

Optionally, as shown in FIG. 5, the power conversion apparatus 00 may further include a second pyrofuse 06, and the second pyrofuse 06 may be configured to be connected between the direct current input end of the inverter 01 and the direct current power supply 10. For example, refer to FIG. 5. The second pyrofuse 06 may be disposed on the positive bus BUS+, to connect the direct current input end of the inverter 01 and the direct current power supply 10. Certainly, in some other embodiments, the second pyrofuse 06 may alternatively be disposed on the negative bus BUS-.

The controller 03 may be further configured to: when the bus voltage is less than the first voltage threshold, and/or the alternating current is greater than the current threshold, control the second pyrofuse 06 to be blown, that is, trigger the second pyrofuse 06 to explode.

To be specific, in this embodiment of this application, when detecting that a short-circuit fault occurs in the power conversion apparatus 00 due to a low bus voltage and/or a large alternating current, the controller 03 can further trigger the second pyrofuse 06 to explode, to disconnect the direct current input end of the inverter 01 from the direct current power supply 10, thereby preventing a large current generated due to the short-circuit fault from flowing into the direct current power supply 10 and damaging a component in the direct current power supply 10, and implementing short-circuit protection.

It may be understood that pyrofuses are disposed at both the alternating current output end and the direct current input end of the inverter 01, and the controller 03 is configured to control both a pyrofuse at the alternating current output end and a pyrofuse at the direct current input end to explode when detecting that a short-circuit fault occurs in the power conversion apparatus 00. This can not only prevent a large current generated due to the short-circuit fault from flowing into the load 20 through the alternating current output end, but also prevent the large current generated due to the short-circuit fault from flowing into the direct current power supply 10 through the direct current input end. Therefore, there are more short-circuit protection objects, and short-circuit protection effect is better.

Optionally, the power conversion apparatus 00 may include a pyrofuse drive circuit corresponding to the first pyrofuse 04 or the second pyrofuse 06. The controller 03 may be connected to a corresponding pyrofuse through a pyrofuse drive circuit, and when determining that a short-circuit fault occurs in the power conversion apparatus 00, the controller 03 may transmit a pyrofuse blown instruction to the pyrofuse drive circuit, to indicate the pyrofuse drive circuit to trigger the corresponding pyrofuse to explode.

Optionally, the sampling circuit 02 in embodiments of this application may include a sampling resistor.

Optionally, the controller 03 in embodiments of this application may include a micro-controller unit (micro-controller unit, MCU) or a field programmable gate array (field programmable gate array, FPGA). A type of the controller 03 is not limited in embodiments of this application.

In conclusion, this embodiment of this application provides the power conversion apparatus. The power conversion apparatus includes the inverter, the sampling circuit, the controller, and the first pyrofuse connected between the inverter and the load. The sampling circuit can sample the bus voltage between the positive bus and the negative bus that are connected to the direct current input end of the inverter, and the alternating current at the alternating current output end of the inverter. The controller can reliably determine, based on a low bus voltage or a large alternating current, that a short-circuit fault occurs in the power conversion apparatus. Therefore, fault detection efficiency is high. In addition, when determining that the short-circuit fault occurs in the power conversion apparatus, the controller can further control the first pyrofuse to be blown. In other words, the first pyrofuse can be quickly blown under control of the controller, so that the inverter is quickly disconnected from the load. In this way, a large current generated due to a short circuit can be quickly prevented from flowing into the load and damaging the load, thereby implementing fast short-circuit protection, and further preventing the short-circuit fault from spreading, so that short-circuit protection effect is good.

Embodiments of this application further provide another power conversion apparatus with a short-circuit protection function. As shown in FIG. 6, the power conversion apparatus includes an inverter 01, a sampling circuit 02, a controller 03, and a first pyrofuse 04, a direct current input end of the inverter 01 is configured to connect to a direct current power supply 10 through a positive bus BUS+ and a negative bus BUS-, an alternating current output end of the inverter 01 is configured to connect to a load 20 through a plurality of phase wires, the sampling circuit 02 is separately connected to the direct current input end of the inverter 01, the alternating current output end of the inverter 01, and the controller 03, the controller 03 is further connected to the first pyrofuse 04, and the first pyrofuse 04 is configured to be connected between the alternating current output end of the inverter 01 and the load 20. In addition, the inverter 01 shown in FIG. 6 is also a three-phase inverter. Based on FIG. 6 and a circuit topology schematic of a three-phase inverter shown in FIG. 4, it can be seen that two capacitors C1 and C2 are connected in series between the positive bus BUS+ and the negative bus BUS-, and a series connection node N of the two capacitors C1 and C2 may be referred to as a bus neutral point.

The sampling circuit 02 is configured to: sample a first half-bus voltage between the bus neutral point N and one of the positive bus BUS+ and the negative bus BUS-, and an alternating current at the alternating current output end.

As described above, the bus neutral point is the series connection node N of the two capacitors C1 and C2 that are connected in series between the positive bus BUS+ and the negative bus BUS-. To be specific, in embodiments of this application, on the basis that sampling points are respectively disposed at the direct current input end and the alternating current output end that are of the inverter 01, a direct current voltage sampled by the sampling circuit 02 can include a half-bus voltage between the bus neutral point N and the positive bus BUS+ and/or the negative bus BUS- connected to the direct current input end. A half-bus voltage between the positive bus BUS+ and the bus neutral point N is a difference between a direct current voltage Vdc+ on the positive bus BUS+ and a voltage at the bus neutral point N, and a half-bus voltage between the negative bus BUS- and the bus neutral point N is a difference between a direct current voltage Vdc- on the negative bus BUS- and the voltage at the bus neutral point N.

The controller 03 is configured to: when the first half-bus voltage is less than a third voltage threshold, and/or an alternating current is greater than a current threshold, control the first pyrofuse 04 to be blown.

When the first half-bus voltage is less than the third voltage threshold, it can also indicate that a short-circuit fault occurs in the power conversion apparatus 00. To be specific, in this embodiment of this application, the controller 03 can obtain the first half-bus voltage and the alternating current by using the sampling circuit 02; and when detecting that the short-circuit fault occurs in the power conversion apparatus 00 due to a low first half-bus voltage and/or a large alternating current, the controller 03 can control the first pyrofuse 04 to be blown, to disconnect the alternating current output end of the inverter 01 from the load 20, thereby preventing a large current generated due to the short-circuit fault from flowing into the load 20 and damaging a component in the load 20, and implementing short-circuit protection.

It may be understood that the short-circuit fault determined by the controller 03 when the controller 03 detects that the first half-bus voltage is less than the third voltage threshold may be a half-bus short-circuit fault. In addition, a half-bus short-circuit fault corresponding to the first half-bus voltage between the positive bus BUS+ and the bus neutral point N is a positive half-bus short-circuit fault, and a half-bus short-circuit fault corresponding to the first half-bus voltage between the negative bus BUS- and the bus neutral point N is a negative half-bus short-circuit fault. That is, in yet another implementation, the controller 03 can further implement short-circuit protection for the half-bus short-circuit fault. For a short-circuit fault corresponding to a case in which the alternating current is greater than the current threshold, refer to the foregoing descriptions. Details are not described again.

In conclusion, this embodiment of this application provides the power conversion apparatus. The power conversion apparatus includes the inverter, the sampling circuit, the controller, and the first pyrofuse connected between the inverter and the load. The sampling circuit can sample the half-bus voltage between the bus neutral point and the positive bus and/or the negative bus connected to the direct current input end of the inverter, and the alternating current at the alternating current output end of the inverter. The controller can reliably determine, based on a low half-bus voltage or a large alternating current, that a short-circuit fault occurs in the power conversion apparatus. Therefore, fault detection efficiency is high. In addition, when determining that the short-circuit fault occurs in the power conversion apparatus, the controller can further control the first pyrofuse to be blown. In other words, the first pyrofuse can be quickly blown under control of the controller, so that the inverter is quickly disconnected from the load. In this way, a large current generated due to a short circuit can be quickly prevented from flowing into the load and damaging the load, thereby implementing fast short-circuit protection, and further preventing the short-circuit fault from spreading, so that short-circuit protection effect is good.

Optionally, with reference to FIG. 3, it can be seen that the power conversion apparatus 00 may further include alternating current relays 05 connected between the inverter 01 and the load 20. For descriptions of the alternating current relay 05, refer to the foregoing descriptions. Details are not described herein again.

Optionally, for a half-bus short-circuit fault scenario, in a first embodiment, the controller 03 may be further configured to: when the first half-bus voltage is less than the third voltage threshold, and the alternating current is greater than the current threshold, control the alternating current relay 05 to be turned off; and after controlling the alternating current relay 05 to be turned off, and when detecting that energy flowing through the first pyrofuse 04 reaches a blown energy value required for the first pyrofuse 04 to be blown, control the first pyrofuse 04 to be blown.

Herein, that the first half-bus voltage is less than the third voltage threshold may mean that an instantaneous value of the first half-bus voltage at a moment is less than the third voltage threshold. On this basis, the controller 03 may further reliably determine, on the basis that the alternating current is greater than the current threshold, whether a half-bus short-circuit fault occurs. In addition, in this embodiment of this application, when detecting that the half-bus short-circuit fault occurs because the first half-bus voltage is less than the third voltage threshold and the alternating current is greater than the current threshold, the controller 03 can first control the alternating current relay 05 to be turned off; and then, if the energy flowing through the first pyrofuse 04 reaches the blown energy because the alternating current relay 05 is not reliably turned off, the controller 03 controls the first pyrofuse 04 to be blown. In this way, with reference to the foregoing descriptions, it can be learned that not only better short-circuit protection can be implemented, but also the first pyrofuse 04 can be prevented from being mistakenly blown.

Optionally, in some embodiments, the sampling circuit 02 may be further configured to sample a second half-bus voltage between the bus neutral point N and the other one of the positive bus BUS+ and the negative bus BUS-. For example, it is assumed that the first half-bus voltage is a half-bus voltage between the positive bus BUS+ and the bus neutral point N (also referred to as a positive half-bus voltage). In this case, the second half-bus voltage is a half-bus voltage between the negative bus BUS- and the bus neutral point N (also referred to as a negative half-bus voltage). On the contrary, it is assumed that the first half-bus voltage is a negative half-bus voltage between the negative bus BUS- and the bus neutral point N. In this case, the second half-bus voltage is a positive half-bus voltage between the positive bus BUS+ and the bus neutral point N.

In addition, the controller 03 may be configured to: when the first half-bus voltage is less than the third voltage threshold, the alternating current is greater than the current threshold, and a difference between the first half-bus voltage and the second half-bus voltage is greater than a second voltage difference threshold, control the alternating current relay 05 to be turned off.

To be specific, the controller 03 may further obtain the second half-bus voltage sampled by the sampling circuit 02; and on the basis that the first half-bus voltage is less than the third voltage threshold and the alternating current is greater than the current threshold, the controller 03 may further reliably determine whether a half-bus short-circuit fault occurs based on the difference between the first half-bus voltage and the second half-bus voltage. Therefore, fault detection precision is higher, and short-circuit protection effect is better.

Alternatively, in the first embodiment, the controller 03 may be configured to: when the first half-bus voltage is less than the third voltage threshold and remains less than the third voltage threshold for fourth duration, control the alternating current relay 05 to be turned off; and after controlling the alternating current relay 05 to be turned off, and when detecting that the energy flowing through the first pyrofuse 04 reaches the blown energy value required for the first pyrofuse 04 to be blown, control the first pyrofuse 04 to be blown.

To be specific, in this embodiment of this application, when detecting that the first half-bus voltage remains less than the third voltage threshold within the fourth duration, and a non-instantaneous value of the first half-bus voltage is less than the third voltage threshold, the controller 03 may further directly control the alternating current relay 05 to be turned off without considering a magnitude of the alternating current.

Optionally, the controller 03 may be configured to: when the first half-bus voltage is less than the third voltage threshold and remains less than the third voltage threshold for the fourth duration, and the alternating current is less than or equal to the current threshold, control the alternating current relay 05 to be turned off.

As described above, when the first half-bus voltage is less than the third voltage threshold and remains less than the third voltage threshold for the fourth duration, it can indicate a half-bus short-circuit fault. On the basis that the first half-bus voltage is less than the third voltage threshold and remains less than the third voltage threshold for the fourth duration, when the alternating current is still less than or equal to the current threshold, it can indicate that the half-bus short-circuit fault in this case is a non-serious half-bus short-circuit fault. Correspondingly, it can be further learned that, on the basis that the first half-bus voltage is less than the third voltage threshold and remains less than the third voltage threshold for the fourth duration, when the alternating current is still greater than the current threshold, it can indicate that the half-bus short-circuit fault is a serious half-bus short-circuit fault.

To be specific, in this embodiment of this application, when detecting that the half-bus short-circuit fault is the non-serious half-bus short-circuit fault, the controller 03 can first control the alternating current relay 05 to be turned off; and then when determining, based on the energy flowing through the first pyrofuse 04, that the alternating current relay 05 is not reliably turned off, the controller 03 further controls the first pyrofuse 04 to be blown, to implement short-circuit protection. For the serious bus short-circuit fault, because there is a delay from time when the alternating current relay 05 is first controlled to be turned off to time when the first pyrofuse 04 is then controlled to be blown, the controller 03 may be configured to directly control the first pyrofuse 04 to be blown, and does not first control the alternating current relay 05 to be turned off.

Optionally, in some embodiments, the sampling circuit 02 may be further configured to sample a second half-bus voltage between the bus neutral point and the other one of the positive bus BUS+ and the negative bus BUS-.

In addition, the controller 03 may be configured to: when the first half-bus voltage is less than the third voltage threshold and remains less than the third voltage threshold for the fourth duration, and a difference between the first half-bus voltage and the second half-bus voltage is greater than a second voltage difference threshold and remains greater than the second voltage difference threshold for the fourth duration, control the alternating current relay 05 to be turned off.

To be specific, the controller 03 may further obtain the second half-bus voltage sampled by the sampling circuit 02; and when the first half-bus voltage is less than the third voltage threshold and remains less than the third voltage threshold for the fourth duration, the controller 03 may further reliably determine whether a half-bus short-circuit fault occurs based on the difference between the first half-bus voltage and the second half-bus voltage. Therefore, fault detection precision is higher, and short-circuit protection effect is better.

Certainly, in some embodiments, when detecting that the first half-bus voltage is less than the third voltage threshold and remains less than the third voltage threshold for the fourth duration, and the difference between the first half-bus voltage and the second half-bus voltage is greater than the second voltage difference threshold and remains greater than the second voltage difference threshold for the fourth duration, the controller 03 can further determine that a bus short-circuit fault in this case is a non-serious bus short-circuit fault on the basis that a detected alternating current is less than or equal to the current threshold, and then choose to control the alternating current relay 05 to be turned off.

Optionally, in a second embodiment, the controller 03 may be configured to: when the first half-bus voltage is less than the third voltage threshold and remains less than the third voltage threshold for the fourth duration, and the alternating current is greater than the current threshold, control the first pyrofuse 04 to be blown.

With reference to the foregoing descriptions, on the basis that the first half-bus voltage is less than the third voltage threshold and remains less than the third voltage threshold for the fourth duration, when the alternating current is still greater than the current threshold, it can indicate that a half-bus short-circuit fault is a serious half-bus short-circuit fault. To be specific, in this embodiment of this application, when detecting that the half-bus short-circuit fault is the serious half-bus short-circuit fault, the controller 03 can directly control the first pyrofuse 04 to be blown, to disconnect the inverter 01 from the load 20, and implement short-circuit protection, and does not first control the alternating current relay 05 to be turned off. In this way, a serious fault caused by a delay from time when the alternating current relay 05 is not reliably turned off to time when the first pyrofuse 04 is then controlled to be blown can be prevented from spreading, and good short-circuit protection can be quickly implemented.

Optionally, in some embodiments, the sampling circuit 02 may be further configured to sample a second half-bus voltage between the bus neutral point and the other one of the positive bus BUS+ and the negative bus BUS-.

The controller 03 may be configured to: when the first half-bus voltage is less than the third voltage threshold and remains less than the third voltage threshold for the fourth duration, the alternating current is greater than the current threshold, and a difference between the first half-bus voltage and the second half-bus voltage is greater than a second voltage difference threshold and remains greater than the second voltage difference threshold for the fourth duration, control the first pyrofuse 04 to be blown.

To be specific, the controller 03 may further obtain the second half-bus voltage sampled by the sampling circuit 02; and when the first half-bus voltage is less than the third voltage threshold and remains less than the third voltage threshold for the fourth duration, the controller 03 may further reliably determine whether a serious half-bus short-circuit fault occurs based on the difference between the first half-bus voltage and the second half-bus voltage. Therefore, fault detection precision is higher, and short-circuit protection effect is better.

Optionally, with reference to FIG. 5, it can be seen that the power conversion apparatus 00 may further include a second pyrofuse 06, and the second pyrofuse 06 may be configured to be connected between the direct current input end and the direct current power supply 10.

The controller 03 may be further configured to: when the first half-bus voltage is less than the third voltage threshold, and/or the alternating current is greater than the current threshold, control the second pyrofuse 06 to be blown.

To be specific, in this embodiment of this application, when detecting that a short-circuit fault occurs in the power conversion apparatus 00 due to a low first half-bus voltage and/or a large alternating current, the controller 03 can further trigger the second pyrofuse 06 to explode, to disconnect the direct current input end of the inverter 01 from the direct current power supply 10, thereby preventing a large current generated due to the short-circuit fault from flowing into the direct current power supply 10 and damaging a component in the direct current power supply 10, and implementing short-circuit protection.

In conclusion, this embodiment of this application provides the power conversion apparatus. The power conversion apparatus includes the inverter, the sampling circuit, the controller, and the first pyrofuse connected between the inverter and the load. The sampling circuit can sample the half-bus voltage between the bus neutral point and the positive bus and/or the negative bus connected to the direct current input end of the inverter, and the alternating current at the alternating current output end of the inverter. The controller can reliably determine, based on a low half-bus voltage or a large alternating current, that a short-circuit fault occurs in the power conversion apparatus. Therefore, fault detection efficiency is high. In addition, when determining that the short-circuit fault occurs in the power conversion apparatus, the controller can further control the first pyrofuse to be blown. In other words, the first pyrofuse can be quickly blown under control of the controller, so that the inverter is quickly disconnected from the load. In this way, a large current generated due to a short circuit can be quickly prevented from flowing into the load and damaging the load, thereby implementing fast short-circuit protection, and further preventing the short-circuit fault from spreading, so that short-circuit protection effect is good.

It can be learned from the foregoing descriptions that the power conversion apparatus 00 provided in embodiments of this application can implement short-circuit protection in the following plurality of short-circuit fault scenarios: (1) A single-stage pack short-circuit fault occurs; (2) a short-circuit fault occurs due to an insulation failure of an energy storage battery to the ground; (3) a bus short-circuit fault occurs; and (4) a half-bus short-circuit occurs. Therefore, short-circuit protection is comprehensive and applicable to a wide range of scenarios. Optionally, for the bus short-circuit fault, in some embodiments, the controller 03 may further determine, by detecting whether the first half-bus voltage or the second half-bus voltage is less than a fourth voltage threshold, whether the bus short-circuit fault occurs.

Optionally, as described above, parameters such as the current threshold, the voltage threshold, the duration, and the blown energy value may all be fixed values pre-stored in the controller 03, and certainly may alternatively be flexibly adjusted. For example, the following Table 1 shows parameters stored in the controller 03.

The first current threshold may be a current threshold 1, the second current threshold may be a current threshold 2, and the current threshold 1 is different from the current threshold 2. The first voltage threshold may be a voltage threshold 1, the second voltage threshold may be a voltage threshold 2, the third voltage threshold may be a voltage threshold 3, the first voltage difference threshold may be a voltage threshold 4, the second voltage difference threshold may be a voltage threshold 5, the voltage average value threshold may be a voltage threshold 6, and the fourth voltage threshold may be a voltage threshold 7. In addition, at least the voltage threshold 2 is less than the voltage threshold 1, and other voltage thresholds may be different or the same. The first duration may be duration t1, the second duration may be duration t2, the third duration may be duration t3, the fourth duration may be duration t4, and specific duration from time at which the alternating current relay 05 is controlled to be turned off to time at which the first pyrofuse 04 is triggered to be blown may be duration t5. In addition, in the scenario in which the short-circuit fault occurs due to the insulation failure of the energy storage battery to the ground, specific duration from time at which the alternating current relay 05 is controlled to be turned off to time at which the first pyrofuse 04 is triggered to be blown may be duration t6, and duration in which the energy flowing through the first pyrofuse 04 reaches the blown energy value may be duration t7. Moreover, duration may be different or may be the same. The blown energy value may be an energy threshold 1.

**Table 1**

| Voltage | Current | Energy | Time |
|---|---|---|---|
| Voltage threshold 1 | Current threshold 1 | Energy threshold 1 | t1 |
| Voltage threshold 2 | Current threshold 2 | | t2 |
| Voltage threshold 3 | | | t3 |
| Voltage threshold 4 | | | t4 |
| Voltage threshold 5 | | | t5 |
| Voltage threshold 6 | | | t6 |
| Voltage threshold 7 | | | t7 |

Optionally, with reference to the foregoing descriptions, the following embodiment provides preferred control manners of the controller 03 in different short-circuit fault scenarios.

For (1) the single-stage pack short-circuit fault, the controller 03 can be configured to perform the following operations.
(1) When the bus voltage is less than the voltage threshold 1 and remains less than the voltage threshold 1 for the duration t1, the controller 03 can be configured to: immediately deliver an instruction to stop sending a PWM driver gating signal, to enable a semiconductor device in the inverter 01 to stop operating, and control the alternating current relay 05 to be turned off. In addition, after the duration t5, when detecting that the energy flowing through the first pyrofuse 04 reaches the blown energy value, that is, alternating current energy flowing through the first pyrofuse 04 is greater than the energy threshold 1 within the duration t7, the controller 03 can be configured to trigger the first pyrofuse 04 to explode.
(2) When the alternating current is greater than the current threshold 1, the controller 03 can be configured to: immediately deliver an instruction to stop sending a PWM driver gating signal, to enable a semiconductor device in the inverter 01 to stop operating, and control the alternating current relay 05 to be turned off. In addition, after the duration t5, when detecting that the energy flowing through the first pyrofuse 04 reaches the blown energy value, the controller 03 can be configured to trigger the first pyrofuse 04 to explode.

For (2) the short-circuit fault caused by the insulation failure of the energy storage battery to the ground, the controller 03 can be configured to perform the following operations.

When an absolute value of a sum of common mode currents of all the phases is greater than the current threshold 2 and remains greater than the current threshold 2 for the duration t3, the controller 03 can be configured to: immediately deliver an instruction to stop sending a PWM driver gating signal, to enable a semiconductor device in the inverter 01 to stop operating, and control the alternating current relay 05 to be turned off. In addition, after the duration t6, when detecting that the energy flowing through the first pyrofuse 04 reaches the blown energy value, the controller 03 can be configured to trigger the first pyrofuse 04 to explode.

For (3) the bus short-circuit fault, the controller 03 can be configured to perform the following operations.
(1) When the bus voltage is less than the voltage threshold 2 (or the half-bus voltage is less than the voltage threshold 7) and remains less than the voltage threshold 2 for the duration t2;
   the average value of the bus voltage in the first time period is greater than the voltage threshold 6 and remains greater than the voltage threshold 6 for the duration t2;
   the difference between the average value of the bus voltage in the first time period and the average value of the bus voltage in the second time period is greater than the voltage threshold 4; and
   the alternating current is less than or equal to the current threshold 1, the controller 03 can be configured to: immediately deliver an instruction to stop sending a PWM driver gating signal, to enable a semiconductor device in the inverter 01 to stop operating, and control the alternating current relay 05 to be turned off. In addition, after the duration t5, when detecting that the energy flowing through the first pyrofuse 04 reaches the blown energy value, the controller 03 can be configured to trigger the first pyrofuse 04 to explode.
(2) When the bus voltage is less than the voltage threshold 2 (or the half-bus voltage is less than the voltage threshold 7) and remains less than the voltage threshold 2 for the duration t2;

the average value of the bus voltage in the first time period is greater than the voltage threshold 6 and remains greater than the voltage threshold 6 for the duration t2;
the difference between the average value of the bus voltage in the first time period and the average value of the bus voltage in the second time period is greater than the voltage threshold 4; and
the alternating current is greater than the current threshold 1, the controller 03 can be configured to immediately trigger the first pyrofuse 04 to be blown.

For (4) the half-bus short-circuit fault, the controller 03 can be configured to perform the following operations.
(1) When the first half-bus voltage is less than the voltage threshold 3 (or the second half-bus voltage is less than the voltage threshold 3);
   the difference between the first half-bus voltage and the second half-bus voltage is greater than the voltage threshold 5; and
   the alternating current is greater than the current threshold 1, the controller 03 can be configured to: immediately deliver an instruction to stop sending a PWM driver gating signal, to enable a semiconductor device in the inverter 01 to stop operating, and control the alternating current relay 05 to be turned off. In addition, after the duration t5, when detecting that the energy flowing through the first pyrofuse 04 reaches the blown energy value, the controller 03 can be configured to trigger the first pyrofuse 04 to explode.
(2) When the first half-bus voltage is less than the voltage threshold 3 (or the second half-bus voltage is less than the voltage threshold 3) and remains less than the voltage threshold 3 for the duration t4;
   the difference between the first half-bus voltage and the second half-bus voltage is greater than the voltage threshold 5 and remains greater than the voltage threshold 5 for the duration t4; and
   the alternating current is less than or equal to the current threshold 1, the controller 03 can be configured to: immediately deliver an instruction to stop sending a PWM driver gating signal, to enable a semiconductor device in the inverter 01 to stop operating, and control the alternating current relay 05 to be turned off. In addition, after the duration t5, when detecting that the energy flowing through the first pyrofuse 04 reaches the blown energy value, the controller 03 can be configured to trigger the first pyrofuse 04 to explode.
(3) When the first half-bus voltage is less than the voltage threshold 3 (or the second half-bus voltage is less than the voltage threshold 3) and remains less than the voltage threshold 3 for the duration t4;
   the difference between the first half-bus voltage and the second half-bus voltage is greater than the voltage threshold 5 and remains greater than the voltage threshold 5 for the duration t4; and
   the alternating current is greater than the current threshold 1, the controller 03 can be configured to immediately trigger the first pyrofuse 04 to be blown.

It may be understood that the controller 03 does not first determine a short-circuit fault scenario. Instead, the controller 03 may determine a corresponding short-circuit fault scenario based on the foregoing conditions, and implement short-circuit protection for different short-circuit fault scenarios. Therefore, short-circuit protection scenarios are diverse, and protection is more comprehensive.

Embodiments of this application further provide a short-circuit protection method for a power conversion apparatus. The method can be applied to the power conversion apparatus 00 provided in the embodiment shown in FIG. 2. For example, the method can be performed by the controller 03 in the power conversion apparatus 00. The method includes:
Step A1: Obtain a bus voltage between a positive bus and a negative bus, and an alternating current at an alternating current output end.

As shown in FIG. 2, a power conversion apparatus 00 includes an inverter 01, a direct current input end of the inverter 01 is configured to connect to a direct current power supply 10 through a positive bus BUS+ and a negative bus BUS-, and an alternating current output end of the inverter 01 is configured to connect to a load 20 through a plurality of phase wires.

In addition, it can be further seen from FIG. 2 that the power conversion apparatus 00 further includes a sampling circuit 02. The sampling circuit 02 is separately connected to the direct current input end of the inverter 01, the alternating current output end of the inverter 01, and the controller 03. The controller 03 can obtain, by using the sampling circuit 02, a bus voltage between the positive bus BUS+ and the negative bus BUS- that are connected to the direct current input end of the inverter 01, and an alternating current at the alternating current output end of the inverter 01.

Step A2: When the bus voltage is less than a first voltage threshold, and/or the alternating current is greater than a current threshold, control a first pyrofuse to be blown.

As shown in FIG. 2, the power conversion apparatus 00 further includes a first pyrofuse 04, and the first pyrofuse 04 is configured to be connected between the alternating current output end of the inverter 01 and the load 20. In this way, when detecting that a short-circuit fault occurs in the power conversion apparatus 00 due to a low bus voltage and/or a large alternating current, the controller 03 controls the first pyrofuse 04 to be blown, to disconnect the alternating current output end of the inverter 01 from the load 20, thereby preventing a large current generated due to the short-circuit fault from flowing into the load 20 and damaging a component in the load 20, and implementing short-circuit protection.

It may be understood that the short-circuit protection method has basically same implementations and technical effects as the power conversion apparatus 00 shown in FIG. 2 described in the foregoing embodiments. Therefore, for brevity, the implementations and the technical effects of the short-circuit protection method are not described herein again.

Embodiments of this application further provide a short-circuit protection method for a power conversion apparatus. The method can be applied to the power conversion apparatus 00 provided in the embodiment shown in FIG. 6. For example, the method can be performed by the controller 03 in the power conversion apparatus 00. The method includes:
Step B1: Obtain a first half-bus voltage between a bus neutral point and one of a positive bus and a negative bus, and an alternating current at an alternating current output end.

As shown in FIG. 6, a power conversion apparatus 00 includes an inverter 01, a direct current input end of the inverter 01 is configured to connect to a direct current power supply 10 through a positive bus BUS+ and a negative bus BUS-, and an alternating current output end of the inverter 01 is configured to connect to a load 20 through a plurality of phase wires. A bus neutral point is a series connection node N of two capacitors C1 and C2 that are connected in series between the positive bus BUS+ and the negative bus BUS-.

In addition, it can be further seen from FIG. 6 that the power conversion apparatus 00 further includes a sampling circuit 02. The sampling circuit 02 is separately connected to the direct current input end of the inverter 01, the alternating current output end of the inverter 01, and the controller 03. The controller 03 can obtain, by using the sampling circuit 02, a first half-bus voltage between the bus neutral point and the one of the positive bus BUS+ and the negative bus BUS- that are connected to the direct current input end of the inverter 01, and an alternating current at the alternating current output end of the inverter 01.

Step B2: When the first half-bus voltage is less than a third voltage threshold, and/or the alternating current is greater than a current threshold, control a first pyrofuse to be blown.

As shown in FIG. 6, the power conversion apparatus 00 further includes a first pyrofuse 04, and the first pyrofuse 04 is configured to be connected between the alternating current output end of the inverter 01 and the load 20. In this way, when detecting that a short-circuit fault occurs in the power conversion apparatus 00 due to a low first half-bus voltage and/or a large alternating current, the controller 03 controls the first pyrofuse 04 to be blown, to disconnect the alternating current output end of the inverter 01 from the load 20, thereby preventing a large current generated due to the short-circuit fault from flowing into the load 20 and damaging a component in the load 20, and implementing short-circuit protection.

It may be understood that the short-circuit protection method has basically same implementations and technical effects as the power conversion apparatus 00 shown in FIG. 6 described in the foregoing embodiments. Therefore, for brevity, the implementations and the technical effects of the short-circuit protection method are not described herein again.

Embodiments of this application further provide a photovoltaic power generation system. With reference to FIG. 1 and FIG. 2, it can be seen that the photovoltaic power generation system includes a power conversion apparatus 00 and a first pyrofuse 04, a direct current input end of the power conversion apparatus 00 is configured to connect to a photovoltaic panel or an energy storage battery (that is, a direct current power supply 10) through a positive bus BUS+ and a negative bus BUS-, an alternating current output end of the power conversion apparatus 00 is configured to connect to a load 20 or a power grid 30, and the first pyrofuse 04 is configured to be connected between the power conversion apparatus 00 and the load 20 or the power grid 30.

The power conversion apparatus 00 is configured to: convert a direct current DC provided by the photovoltaic panel or the energy storage battery into an alternating current AC, and then output the alternating current AC to the load 20 or the power grid 30, and is further configured to: sample a bus voltage between the positive bus BUS+ and the negative bus BUS- and an alternating current at the alternating current output end; and when the bus voltage is less than a first voltage threshold, and/or the alternating current is greater than a current threshold, control the first pyrofuse 04 to be blown, to disconnect from the load 20 or the power grid 30.

It may be understood that, with reference to the foregoing descriptions, the direct current input end of the inverter 01 in the power conversion apparatus 00 may be configured to connect to the direct current power supply 10 through the positive bus BUS+ and the negative bus BUS-, and the alternating current output end of the inverter 01 may be configured to connect to the load 20 or the power grid 30. In addition, a sampling circuit 02 in the power conversion apparatus 00 may sample the bus voltage between the positive bus BUS+ and the negative bus BUS-, and the alternating current at the alternating current output end. In addition, when detecting that the bus voltage is less than the first voltage threshold, and/or that the alternating current is greater than the current threshold, a controller 03 in the power conversion apparatus 00 may control the first pyrofuse 04 to be blown.

Certainly, as described above, in some embodiments, the power conversion apparatus 00 can further sample a first half-bus voltage between a bus neutral point and one of the positive bus and the negative bus, and the alternating current at the alternating current output end; and when the first half-bus voltage is less than a third voltage threshold, and/or the alternating current is greater than the current threshold, the power conversion apparatus 00 can control the first pyrofuse 04 to be blown, to disconnect from the load 20 or the power grid 30.

Optionally, in some embodiments, the photovoltaic power generation system may further include an energy storage cabinet (or referred to as an energy storage box), and both the energy storage battery and the first pyrofuse 04 may be disposed in the energy storage cabinet. In other words, the first pyrofuse 04 may be independent of the power conversion apparatus 00, and is integrated with the energy storage battery in the energy storage cabinet. That is, the first pyrofuse 04 may be located outside the power conversion apparatus 00. Alternatively, in some embodiments, the first pyrofuse 04 may be integrated with the power conversion apparatus 00. That is, the first pyrofuse 04 may be located inside the power conversion apparatus 00, or the power conversion apparatus 00 includes the first pyrofuse 04. The same applies to a second pyrofuse 06. Details are not described herein again.

In embodiments of this application, terms "first", "second", and "third" are merely used for description, but cannot be understood as indications or implications of relative importance. The term "at least one" means one or more, and "a plurality of" means two or more. The term "and/or" in this application describes only an association relationship for describing associated objects and represents that three relationships may exist. For example, A and/or B may represent the following three cases: Only A exists, both A and B exist, and only B exists. In addition, the character "/" generally indicates an "or" relationship between associated objects.

The foregoing descriptions are merely optional implementations of this application, but the protection scope of this application is not limited thereto. Any equivalent modification or replacement readily figured out by a person skilled in the art within the technical scope disclosed in this application shall fall within the protection scope of this application. Therefore, the protection scope of this application shall be subject to the protection scope of the claims.

## Claims

1. A power conversion apparatus, wherein the power conversion apparatus comprises an inverter, a sampling circuit, a controller, and a first pyrofuse, a direct current input end of the inverter is configured to connect to a direct current power supply through a positive bus and a negative bus, an alternating current output end of the inverter is configured to connect to a load through a plurality of phase wires, the sampling circuit is separately connected to the direct current input end of the inverter, the alternating current output end of the inverter, and the controller, the controller is further connected to the first pyrofuse, and the first pyrofuse is configured to be connected between the alternating current output end of the inverter and the load;
the sampling circuit is configured to sample a bus voltage between the positive bus and the negative bus, and an alternating current at the alternating current output end; and
the controller is configured to: when the bus voltage is less than a first voltage threshold, and/or the alternating current is greater than a current threshold, control the first pyrofuse to be blown.

2. The power conversion apparatus according to claim 1, wherein the power conversion apparatus further comprises an alternating current relay connected between the inverter and the load; and
the controller is further configured to: when the bus voltage is less than the first voltage threshold and remains less than the first voltage threshold for first duration, control the alternating current relay to be turned off; and after controlling the alternating current relay to be turned off, and when detecting that energy flowing through the first pyrofuse reaches a blown energy value required for blowing the first pyrofuse, control the first pyrofuse to be blown.

3. The power conversion apparatus according to claim 2, wherein the controller is configured to: when the bus voltage is less than the first voltage threshold and remains less than the first voltage threshold for the first duration, and the alternating current is less than or equal to the current threshold, control the alternating current relay to be turned off.

4. The power conversion apparatus according to claim 2 or 3, wherein the controller is further configured to: when the bus voltage is less than a second voltage threshold and remains less than the second voltage threshold for second duration, an average value of the bus voltage in a first time period is greater than a voltage average value threshold and remains greater than the voltage average value threshold for the second duration, and a difference between the average value of the bus voltage in the first time period and an average value of the bus voltage in a second time period is greater than a first voltage difference threshold, control the alternating current relay to be turned off, wherein
the second voltage threshold is less than the first voltage threshold, and duration of the second time period is less than duration of the first time period.

5. The power conversion apparatus according to claim 1, wherein the power conversion apparatus further comprises an alternating current relay connected between the inverter and the load; and
the controller is further configured to: when the alternating current is greater than the current threshold, control the alternating current relay to be turned off; and after controlling the alternating current relay to be turned off, and when detecting that energy flowing through the first pyrofuse reaches a blown energy value required for blowing the first pyrofuse, control the first pyrofuse to be blown.

6. The power conversion apparatus according to claim 5, wherein when the alternating current is an alternating current output to the load through the alternating current output end, the current threshold is a first current threshold; and
when the alternating current is a sum of alternating current common mode currents of all of the plurality of phase wires connected to the alternating current output end, the current threshold is a second current threshold, the second current threshold is different from the first current threshold, and the controller is further configured to: when the sum of the alternating current common mode currents is greater than the second current threshold and remains greater than the second current threshold for third duration, control the alternating current relay to be turned off.

7. The power conversion apparatus according to claim 1, wherein the controller is configured to: when the bus voltage is less than the first voltage threshold and remains less than the first voltage threshold for first duration, and the alternating current is greater than the current threshold, control the first pyrofuse to be blown.

8. The power conversion apparatus according to claim 7, wherein the controller is further configured to: when the bus voltage is less than a second voltage threshold and remains less than the second voltage threshold for second duration, the alternating current is greater than the current threshold, an average value of the bus voltage in a first time period is greater than a voltage average value threshold and remains greater than the voltage average value threshold for the second duration, and a difference between the average value of the bus voltage in the first time period and an average value of the bus voltage in a second time period is greater than a first voltage difference threshold, control the first pyrofuse to be blown, wherein
the second voltage threshold is less than the first voltage threshold, and duration of the second time period is less than duration of the first time period.

9. The power conversion apparatus according to any one of claims 1 to 8, wherein the power conversion apparatus further comprises a second pyrofuse, and the second pyrofuse is configured to be connected between the direct current input end of the inverter and the direct current power supply; and
the controller is further configured to: when the bus voltage is less than the first voltage threshold, and/or the alternating current is greater than the current threshold, control the second pyrofuse to be blown.

10. A power conversion apparatus, wherein the power conversion apparatus comprises an inverter, a sampling circuit, a controller, and a first pyrofuse, a direct current input end of the inverter is configured to connect to a direct current power supply through a positive bus and a negative bus, an alternating current output end of the inverter is configured to connect to a load through a plurality of phase wires, the sampling circuit is separately connected to the direct current input end of the inverter, the alternating current output end of the inverter, and the controller, the controller is further connected to the first pyrofuse, and the first pyrofuse is configured to be connected between the alternating current output end of the inverter and the load;
the sampling circuit is configured to sample a first half-bus voltage between a bus neutral point and one of the positive bus and the negative bus, and an alternating current at the alternating current output end, wherein the bus neutral point is a series connection node of two capacitors connected in series between the positive bus and the negative bus; and
the controller is configured to: when the first half-bus voltage is less than a third voltage threshold, and/or the alternating current is greater than a current threshold, control the first pyrofuse to be blown.

11. The power conversion apparatus according to claim 10, wherein the power conversion apparatus further comprises an alternating current relay connected between the inverter and the load; and
the controller is further configured to: when the first half-bus voltage is less than the third voltage threshold, and the alternating current is greater than the current threshold, control the alternating current relay to be turned off; and after controlling the alternating current relay to be turned off, and when detecting that energy flowing through the first pyrofuse reaches a blown energy value required for blowing the first pyrofuse, control the first pyrofuse to be blown.

12. The power conversion apparatus according to claim 11, wherein the sampling circuit is further configured to sample a second half-bus voltage between the bus neutral point and the other one of the positive bus and the negative bus; and
the controller is configured to: when the first half-bus voltage is less than the third voltage threshold, the alternating current is greater than the current threshold, and a difference between the first half-bus voltage and the second half-bus voltage is greater than a second voltage difference threshold, control the alternating current relay to be turned off.

13. The power conversion apparatus according to claim 10, wherein the power conversion apparatus further comprises an alternating current relay connected between the inverter and the load; and
the controller is configured to: when the first half-bus voltage is less than the third voltage threshold and remains less than the third voltage threshold for fourth duration, control the alternating current relay to be turned off; and after controlling the alternating current relay to be turned off, and when detecting that energy flowing through the first pyrofuse reaches a blown energy value required for blowing the first pyrofuse, control the first pyrofuse to be blown.

14. A photovoltaic power generation system, wherein the photovoltaic power generation system comprises a power conversion apparatus and a first pyrofuse, a direct current input end of the power conversion apparatus is configured to connect to a photovoltaic panel or an energy storage battery through a positive bus and a negative bus, an alternating current output end of the power conversion apparatus is configured to connect to a load or a power grid, and the first pyrofuse is configured to be connected between the power conversion apparatus and the load or the power grid; and
the power conversion apparatus is configured to: convert a direct current provided by the photovoltaic panel or the energy storage battery into an alternating current, and then output the alternating current to the load or the power grid, and is further configured to: sample a bus voltage between the positive bus and the negative bus, and an alternating current at the alternating current output end; and when the bus voltage is less than a first voltage threshold, and/or the alternating current is greater than a current threshold, control the first pyrofuse to be blown, to disconnect from the load or the power grid.
